# EUROPEAN PATENT APPLICATION

(11) **EP 4 284 141 A2**
(43) Date of publication of application: **29.11.2023**
(21) Application number: 23170419.8
(22) Date of filing: 27.04.2023
(51) Int. Cl.: H10B 12/00

(54) **SEMICONDUCTOR DEVICE**

(30) Priority: 02.05.2022 KR 20220054373
(71) Applicant: Samsung Electronics Co., Ltd., Suwon-si, Gyeonggi-do 16677 (KR)
(72) Inventor: KANG, Yoongoo, 16677 Suwon-si (KR); OH, Sangyoon, 16677 Suwon-si (KR); YOO, Wonseok, 16677 Suwon-si (KR); CHONG, Kyeongock, 16677 Suwon-si (KR); KANG, Haeseul, 16677 Suwon-si (KR)
(74) Representative: Marks & Clerk LLP

(57) **Abstract**

A semiconductor device includes an active region; an isolation region on a side surface of the active region; a gate trench intersecting the active region and extending into the isolation region; a gate structure in the gate trench; a first impurity region and a second impurity region in the active region on both sides of the gate structure and spaced apart from each other; a bit line structure including a line portion intersecting the gate structure and a plug portion below the line portion and electrically connected to the first impurity region; and an insulating structure on a side surface of the plug portion. The insulating structure includes a spacer including a first material; an insulating pattern between the plug portion and the spacer and including a second material; and an insulating liner covering a side surface and a bottom surface of the insulating pattern and including a third material.

## Description

### TECHNICAL FIELD

Example embodiments of the present disclosure relate to a semiconductor device and a method of manufacturing the same.

### DICSUSSION OF RELATED ART

Research has been conducted to reduce sizes of components of a semiconductor device and to enhance performance thereof. As sizes of components of a semiconductor device are reduced, defects may occur between conductive regions adjacent to each other. For example, when an insulating structure is formed between two conductive regions, if pinholes are formed in the insulating structure, defects may occur due to a buffer layer disposed below a line portion of one of the conductive regions may be partially etched during an oxide etch such that the line portion may collapse.

### SUMMARY

An example embodiment of the present disclosure is to provide a semiconductor device having reliability.

According to an example embodiment of the present disclosure, a semiconductor device includes an active region; an isolation region disposed on a side surface of the active region; a gate trench intersecting the active region and extending into the isolation region; a gate structure disposed in the gate trench; a first impurity region and a second impurity region disposed in the active region on both sides of the gate structure and spaced apart from each other; a bit line structure including a line portion intersecting the gate structure and a plug portion disposed below the line portion and electrically connected to the first impurity region; and an insulating structure disposed on a side surface of the plug portion, in which the insulating structure includes a spacer including a first material; an insulating pattern disposed between the plug portion and the spacer and including a second material different from the first material; and an insulating liner covering a side surface and a bottom surface of the insulating pattern and including a third material different from the first and second materials.

According to an example embodiment of the present disclosure, a semiconductor device includes an active region; an isolation region disposed on a side surface of the active region; a gate trench intersecting the active region and extending into the isolation region; a gate structure disposed in the gate trench; a first impurity region and a second impurity region disposed in the active region on both sides of the gate structure and spaced apart from each other; a bit line structure including a line portion intersecting the gate structure and a plug portion disposed below the line portion and electrically connected to the first impurity region; a first insulating structure disposed on a first side surface of the plug portion; and a second insulating structure disposed on a second side surface of the plug portion and vertically overlapping the line portion, in which the first side surface of the plug portion is aligned with a side surface of the line portion, the second side surface of the plug portion vertically overlaps a lower surface of the line portion, at least a portion of the first insulating structure is disposed between the plug portion and the second impurity region, the first insulating structure includes a first spacer and an insulating pattern disposed between the first spacer and the first side surface of the plug portion, the second insulating structure includes a second spacer, and a third spacer disposed between the second spacer and the second side surface of the plug portion, each of the first and second spacers includes a silicon carbonitride material, and the insulating pattern includes a material different from the silicon carbonitride material.

According to an example embodiment of the present disclosure, a semiconductor device includes an insulating structure having first and second sides opposing each other; a first conductive region disposed on the first side of the insulating structure; and a second conductive region disposed on the second side of the insulating structure, in which the insulating structure includes a spacer being in contact with the second conductive region and including a first material; an insulating pattern disposed between the first conductive region and the spacer and including a second material different from the first material; and an insulating liner covering a side surface and a bottom surface of the insulating pattern and including a third material different from the first and second materials.

At least some of the above and other features of the invention are set out in the claims.

### BRIEF DESCRIPTION OF DRAWINGS

The above and other aspects, and features of the present disclosure will be more clearly understood from the following detailed description, taken in conjunction with the accompanying drawings, in which:
FIGS. 1, 2A and 2B are diagrams illustrating a semiconductor device according to an example embodiment of the present disclosure;
FIG. 3 is a cross-sectional diagram illustrating a modified example of a semiconductor device according to an example embodiment of the present disclosure;
FIGS. 4A and 4B are cross-sectional diagrams illustrating a modified example of a semiconductor device according to an example embodiment of the present disclosure;
FIGS. 5A and 5B are cross-sectional diagrams illustrating a modified example of a semiconductor device according to an example embodiment of the present disclosure;
FIG. 6 is a diagram illustrating a modified example of a semiconductor device according to an example embodiment of the present disclosure, viewed from above;
FIG. 7 is a cross-sectional diagram illustrating a semiconductor device according to an example embodiment of the present disclosure;
FIG. 8 is a diagram illustrating insulating layers of a semiconductor device according to an example embodiment of the present disclosure;
FIGS. 9, 10, and 12 to 17 are cross-sectional diagrams illustrating a method of manufacturing a semiconductor device according to an example embodiment of the present disclosure; and
FIG. 11 is a gas pulsing diagram illustrating a method of manufacturing a semiconductor device according to an example embodiment of the present disclosure.

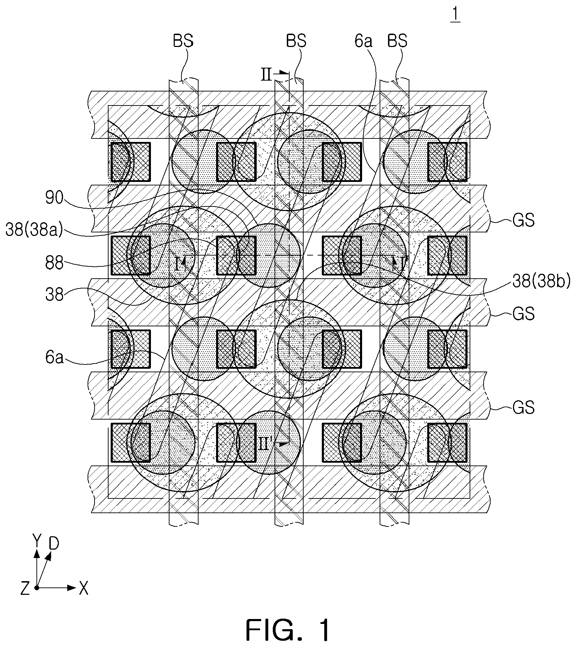

Since the drawings in FIGS. 1-17 are intended for illustrative purposes, the elements in the drawings are not necessarily drawn to scale. For example, some of the elements may be enlarged or exaggerated for clarity purpose.

### DETAILED DESCRIPTION OF THE EMBODIMENTS

Hereinafter, example embodiments of the present disclosure will be described with reference to the accompanying drawings.

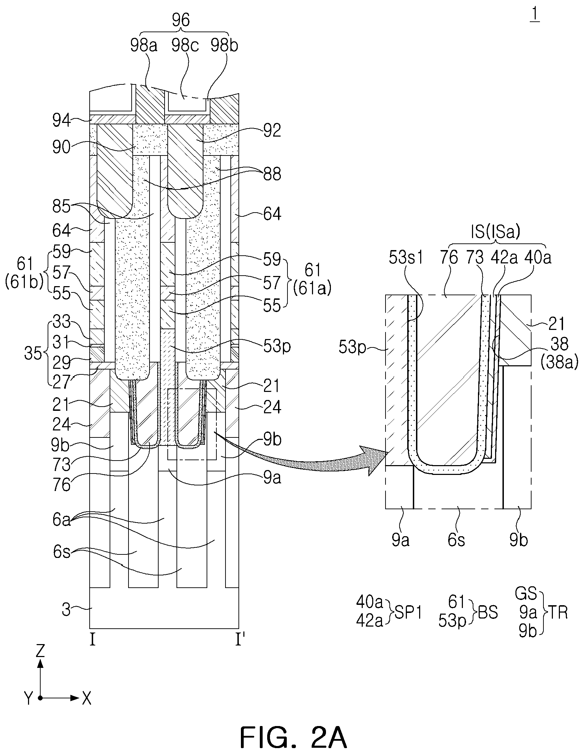

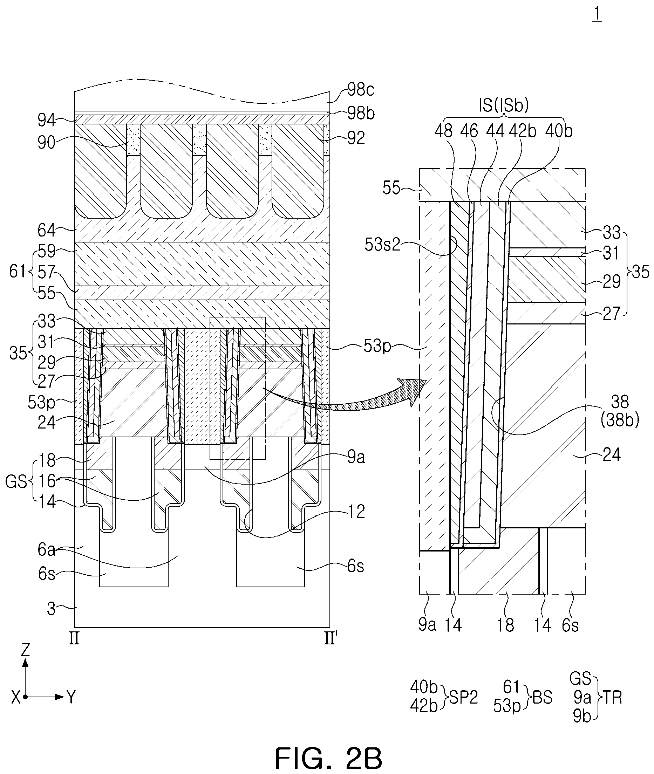

A semiconductor device according to an example embodiment of the present disclosure will be described with reference to FIGS. 1, 2A and 2B. Among FIGS. 1, 2A, and 2B, FIG. 1 is a diagram illustrating a semiconductor device according to an example embodiment of the present disclosure, viewed from above, FIG. 2A is a cross-sectional diagram illustrating a region taken along line I-I' in FIG. 1, and FIG. 2B is a cross-sectional diagram illustrating a region taken along line II-II' in FIG. 1.

Referring to FIGS. 1, 2A and 2B, a semiconductor device 1 according to an example embodiment of the present disclosure may include a substrate 3, an active region 6a on the substrate 3, an isolation region 6s on a side surface of the active region 6a, a gate trench 12 intersecting the active region 6a and extending into the isolation region 6s, a gate structure GS in the gate trench 12, a first impurity region 9a and a second impurity region 9b disposed in the active region 6a on both sides of the gate structure GS and spaced apart from each other, a bit line structure BS including a line portion 61 intersecting the gate structure GS and a plug portion 53p disposed below the line portion 61 and electrically connected to the first impurity region 9a, and an insulating structure IS on side surfaces of the plug portion 53p.

The substrate 3 may be a semiconductor substrate. For example, the substrate 3 may include a group IV semiconductor, a group III-V compound semiconductor, or a group II-VI compound semiconductor. For example, the group IV semiconductor may include silicon (Si), germanium (Ge), or silicon-germanium (SiGe). The group III-V compound semiconductor may include, for example, gallium phosphide (GaP), gallium arsenide (GaAs), indium arsenide (InAs), indium phosphide (InP), gallium antimonide (GaSb), indium antimonide (InSb), or indium gallium arsenide (InGaAs). The group II-VI compound semiconductor may include, for example, cadmium selenide (CdSe), cadmium sulfide (CdS), cadmium telluride (CdTe), zinc oxide (ZnO), zinc selenide (ZnSe), zinc sulfide (ZnS), or zinc telluride (ZnTe). For example, the substrate 3 may include a silicon (Si) material, such as, for example, a single crystal silicon (sc-Si) material. The substrate 3 may be implemented as a silicon (Si) substrate, a silicon on insulator (SOI) substrate, a germanium (Ge) substrate, a germanium on insulator (GOI) substrate, a silicon-germanium (SiGe) substrate, or an epitaxial layer. In addition, the substrate 3 may include one or more semiconductor layers or structures and may include active or operable portions of semiconductor devices.

The isolation region 6s may be configured as a trench isolation layer. The isolation region 6s may be disposed on the substrate 3 and may define the active region 6a. The isolation region 6s may include an insulating material such as silicon oxide (SiOz) and/or silicon nitride (Si₃N₄).

The gate structure GS may have a line shape extending in the first direction X or a bar shape extending in the diagonal direction D of the active region 6a. The diagonal direction D may be a direction intersecting the first direction X while forming an obtuse or acute angle with the first direction X. The line portion 61 of the bit line structure BS may have a line shape extending in a second direction Y perpendicular to the first direction X.

A plurality of the active regions 6a may be disposed. Each of the active regions 6a may have an isolated shape, and may have a bar shape elongated along the diagonal direction D in a plan view. When viewed in plan, the active regions 6a may correspond to portions of the substrate 3 that are surrounded by the isolation region 6s. The active regions 6a may be arranged in parallel to each other such that one of the active regions 6a may have an end portion adjacent to a central portion of a neighboring one of the active regions 6a. A plurality of the gate structures GS may be disposed, and spaced apart from each other in the second direction Y. A plurality of the bit line structures BS may be disposed, and spaced apart from each other in the first direction X. One of the plurality of active regions 6a may intersect a pair of gate structures GS adjacent to each other among the plurality of gate structures GS, and may intersect one of the plurality of bit line structure BS.

Hereinafter, the active region 6a, the gate structure GS, and the bit line structure BS will be mainly described.

The gate structure GS may include a gate dielectric layer 14 covering an internal wall of the gate trench 12, a gate electrode 16 partially filling the gate trench 12 on the gate dielectric layer 14, a gate capping layer 18 filling the other portion of the gate trench 12 on the gate electrode 16.

The gate dielectric layer 14 may include at least one of silicon oxide (SiOz) or a high-k dielectric. The high-k dielectric may have a dielectric constant greater than that of the silicon oxide (SiOz). The gate electrode 16 may include a doped polysilicon (p-Si), a metal, a conductive metal nitride, a metal-semiconductor compound, a conductive metal oxide, graphene, carbon nanotube, or a combination thereof. For example, the gate electrode 16 may be formed of doped polysilicon (p-Si), aluminum (Al), copper (Cu), titanium (Ti), tantalum (Ta), ruthenium (Ru), tungsten (W), molybdenum (Mo), platinum (Pt), nickel (Ni), cobalt (Co), rhodium (Rh), palladium (Pd), iridium (Ir), osmium (Os), silver (Ag), gold (Au), zinc (Zn), vanadium (V), titanium nitride (TiN), tantalum nitride (TaN), tungsten nitride (WN), niobium nitride (NbN), titanium aluminum (TiAl), titanium aluminum nitride (TiAlN), titanium silicide (TiSi₂), titanium silicon nitride (TiSiN), tantalum silicide (TaSi₂), tantalum silicon nitride (TaSiN), ruthenium titanium nitride (RuTiN), nickel silicide (NiSi₂), cobalt silicide (CoSi₂), tungsten silicide (WSi₂), iridium oxide (IrOₓ), ruthenium oxide (RuOₓ), graphene, carbon nanotube, or a combination thereof, but the present disclosure is not limited thereto. The gate electrode 16 may include a single layer or multiple layers of the aforementioned materials. The gate capping layer 18 may include an insulating material, such as, for example, silicon nitride (Si₃N₄).

The first and second impurity regions 9a and 9b in the active region 6a may be spaced apart from each other by the gate structure GS. A channel region in the active region 6a may be located at the intersection of the gate structure GS and the active region 6a. The first and second impurity regions 9a and 9b and the gate structure GS may form a transistor TR. The first and second impurity regions 9a and 9b may be sources/drains of the transistor TR, and may be formed in the active region 6a through an ion implantation process.

The semiconductor device 1 may further include a pad pattern 21 electrically connected to the second impurity region 9b on the second impurity region 9b. The active region 6a may be single crystal silicon (sc-Si), and the pad pattern 21 may be polysilicon (p-Si). The pad pattern 21 may be doped polysilicon (p-Si), such as, for example, doped polysilicon (p-Si) having an N-type conductivity. For example, the pad pattern 21 may be doped with N-type dopants. The N-type dopants may include, for example, phosphorus (P), arsenic (As), etc.

The semiconductor device 1 may further include an insulating barrier pattern 24. The insulating barrier pattern 24 may be in contact with a portion of a side surface of the pad pattern 21 and may penetrate the pad pattern 21. A lower surface of the insulating barrier pattern 24 may be disposed at a level lower (for example, closer to the substrate 3) than a level of a lower surface of the pad pattern 21. An upper surface of the insulating barrier pattern 24 may be coplanar with an upper surface of the pad pattern 21. At least a portion of the insulating barrier pattern 24 may vertically overlap the line portion 61.

The insulating barrier pattern 24 may include an insulating material such as, for example, silicon nitride (Si₃N₄). The insulating barrier pattern 24 may be formed as a silicon nitride (Si₃N₄) layer.

The semiconductor device 1 may further include a buffer structure 35 on the insulating barrier pattern 24.

The buffer structure 35 may be disposed between the line portion 61 and the insulating barrier pattern 24. For example, the buffer structure 35 may be in contact with an upper surface of the insulating barrier pattern 24 and a lower surface of the line portion 61. For example, at least a portion of the buffer structure 35 may be disposed between the insulating barrier pattern 24 and the line portion 61. For example, a portion of the buffer structure 35 may extend from a portion vertically overlapping the line portion 61 to a region not overlapping the line portion 61.

The buffer structure 35 may include a plurality of buffer layers stacked in order. For example, the buffer structure 35 may include a first buffer layer 27, a second buffer layer 29, a third buffer layer 31, and a fourth buffer layer 33 stacked in order. For example, the first buffer layer 27, the second buffer layer 29, the third buffer layer 31, and the fourth buffer layer 33 may be sequentially stacked on the insulating barrier pattern 24.

Each of the second buffer layer 29 and the fourth buffer layer 33 may have a thickness greater than a thickness of each of the first buffer layer 27 and the third buffer layer 31, respectively.

The second buffer layer 29 may be formed of a material having etch selectivity with respect to the materials of the first buffer layer 27 and the third buffer layer 31. The fourth buffer layer 33 may be formed of a material having etch selectivity with respect to the materials of the first to third buffer layers 27, 29, and 31. The first buffer layer 27 may be a silicon oxide (SiOz) layer or a silicon oxide (SiOz)-based insulating material layer. The second buffer layer 29 may be a silicon nitride (Si₃N₄) layer or a silicon nitride (Si₃N₄)-based insulating material layer. The third buffer layer 31 may be a silicon oxide (SiOz) layer or a silicon oxide (SiOz)-based insulating material layer. The fourth buffer layer 33 may be a conductive layer. For example, the fourth buffer layer 33 may be formed as a doped silicon (Si) layer or a conductive material layer which may replace a doped silicon (Si) layer. The fourth buffer layer 33 may be formed of a doped polysilicon (p-Si) layer having an N-type conductivity.

The first buffer layer 27 of the buffer structure 35 may extend from a portion vertically overlapping the line portion 61 to a region not overlapping the line portion 61. At least a portion of the first buffer layer 27 may not vertically overlap the second to fourth buffer layers 29, 31, 33 of the buffer structure 35.

A lower surface of the buffer structure 35, that is, for example, a lower surface of the first buffer layer 27 may be in contact with an upper surface of the insulating barrier pattern 24.

The insulating structure IS may include a first insulating structure ISa on the first side surface 53s1 of the plug portion 53p and a second insulating structure ISb on the second side surface 53s2 of the plug portion 53p.

The first side surface 53s1 of the plug portion 53p may be aligned with the side surface of the line portion 61. The second side surface 53s2 of the plug portion 53p may vertically overlap the line portion 61. The first side surface 53s1 of the plug portion 53p may be disposed in the first direction X, and the second side surface 53s2 of the plug portion 53p may be disposed in the second direction Y. For example, a plurality of first side surfaces 53s1 may be spaced apart from each other in the first direction X, and a plurality of second side surfaces 53s2 may be spaced apart from each other in the second direction Y.

The first insulating structure ISa may include a portion disposed between the first side surface 53s1 of the plug portion 53p and the pad pattern 21, and a portion disposed between the first side surface 53s1 of the plug portion 53p and the second impurity region 9b. For example, an upper surface of the first impurity region 9a may be disposed at a level lower than a level of an upper surface of the second impurity region 9b, and at least a portion of the first insulating structure ISa may be disposed between the second impurity region 9b and the plug portion 53p. In the first insulating structure ISa, a portion disposed between the first side surface 53s1 of the plug portion 53p and the second impurity region 9b may extend into the isolation region 6s, and may be in contact with the isolation region 6s.

The first insulating structure ISa may include a first spacer SP1 spaced apart from the plug portion 53p and including a first material, an insulating pattern 76 disposed between the plug portion 53p and the first spacer SP1 and including a second material different from the first material, and an insulating liner 73 covering a side surface and a bottom surface of the insulating pattern 76 and including a third material different from the first and second materials.

A lower end of the insulating liner 73 may be disposed at a level lower than a level of a lower end of the first spacer SP1. The first spacer SP1 may be a single layer or multiple layers.

The first material may be silicon carbonitride (SiCN). The second material may be silicon nitride (Si₃N₄). The third material may be silicon oxide (SiOz).

The silicon carbonitride (SiCN) of the first material may be a material formed using a hexa-chlorodi-silane (HCD, Si₂Cl₆) precursor. For example, in the silicon carbonitride (SiCN), the "Si" element may be silicon (Si) of a Si source gas such as, for example, hexa-chlorodi-silane (HCD, Si₂Cl₆), and the "C" element may be carbon (C) of a C source gas, such as, for example, ethylene (C₂H₄), cyclopropane (C₃H₆), acetylene (C₂H₂), or the like, and the "N" element may be nitrogen (N) of an N source gas, such as, for example, ammonia (NH₃).

Silicon nitride (Si₃N₄) of the second material may be a material formed using a precursor such as, for example, hexa-chlorodi-silane (HCD, Si₂Cl₆), di-chlorosilane (DCS, SiH₂Cl₂), silane (SiH₄), disilyne (Si₂H₂), diiodosilane (SiH₂I₂), or diisopropylaminosilane (DIPAS). In silicon nitride (Si₃N₄) of the second material, the "Si" element may be silicon (Si) of a Si source gas such as, for example, hexa-chlorodi-silane (HCD, Si₂Cl₆), di-chlorosilane (DCS, SiH₂Cl₂), silane (SiH₄), disilyne (Si₂H₂), diiodosilane (SiH₂I₂), or diisopropylaminosilane (DIPAS), and the "N" element may be nitrogen (N) of an N source gas such as ammonia (NH₃).

Silicon carbonitride (SiCN) described below may be a silicon carbonitride (SiCN) material of the first material, and silicon nitride (Si₃N₄) described below may be a silicon nitride (Si₃N₄) material of the second material.

The first spacer SP1 may include a first layer 40a and a second layer 42a. One of the first layer 40a and the second layer 42a may be an insulating layer formed of the first material, and the other may be an insulating layer formed of the second material. In an example embodiment of the present disclosure, the first spacer SP1 may include a first material layer (first layer 40a) including the first material, and a second material layer (second layer 42a) including the second material, and the second material layer may be disposed between the first material layer and the insulating liner 73.

As an example, in the first insulating structure Isa, the first layer 40a may be an insulating layer formed of the first material, such as, for example, silicon carbonitride (SiCN), and the second layer 42a may be an insulating layer formed of the second material, such as, for example, silicon nitride (Si₃N₄).

As another example, in the first insulating structure ISa, the first layer 40a may be an insulating layer formed of the second material, such as, for example, silicon nitride (Si₃N₄), and the second layer 42a may be an insulating layer formed of the first material, such as, for example, silicon carbonitride (SiCN).

In the first insulating structure Isa, the first layer 40a may be disposed between the second layer 42a and the pad pattern 21, and between the second layer 42a and the isolation region 6s. The first layer 40a may be in contact with the pad pattern 21 and the isolation region 6s. The second layer 42a may be spaced apart from the pad pattern 21 and the isolation region 6s by the first layer 40a. A portion of a side surface of the pad pattern 21 may be in contact with the insulating barrier pattern 24. For example, the pad pattern 21 may include a first side surface in contact with the insulating barrier pattern 24 and a second side surface in contact with the first spacer SP1.

A distance between both side surfaces of the first spacer SP1 may be in the range from about 3 Å to about 10 Å. A distance between both side surfaces of the first spacer SP1 may be a thickness of the first spacer SP1. A width of the insulating pattern 76 may be greater than a thickness of the first spacer SP1.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

The second insulating structure Isb may include a portion disposed between the second side surface 53s2 of the plug portion 53p and the insulating barrier pattern 24, and a portion disposed between the second side surface 53s2 of the plug portion 53p and the buffer structure 35. At least a portion of a lower surface of the second insulating structure Isb may be in contact with the gate capping layer 18 of the gate structure GS.

The second insulating structure Isb may include a first layer 40b, a second layer 42b, a third layer 44, a fourth layer 46, and a fifth layer 48.

In the second insulating structure Isb, the first and second layers 40b and 42b may be referred to as a second spacer SP2. The second spacer SP2 may be in contact with the insulating barrier pattern 24 and the buffer structure 35 below the line portion 61.

The thickness of the second spacer SP2 may be in the range from about 20 Å to about 30 Å.

In the second insulating structure Isb, the third layer 44, the fourth layer 46, and the fifth layer 48 may form the third spacer 44, 46, and 48.

In the second insulating structure Isb, the first layer 40b may be disposed between the second layer 42b and the buffer structure 35, between the second layer 42b and the insulating barrier pattern 24 and between the second layer 42b and the gate capping layer 18. For example, the second layer 42b may be spaced apart from the buffer structure 35, the insulating barrier pattern 24 and the gate capping layer 18 by the first layer 40b.

In the second insulating structure Isb, the first layer 40b of the second spacer SP2 may be in contact with at least one of the buffer structure 35, the insulating barrier pattern 24, or the gate capping layer 18. For example, in the second insulating structure Isb, the first layer 40b of the second spacer SP2 may be in contact with the buffer layers 27, 29, 31, and 33 of the buffer structure 35, the insulating barrier pattern 24 and the gate capping layer 18.

In the second insulating structure Isb, the second layer 42b may be disposed between the third layer 44 and the first layer 40b. In the second insulating structure Isb, the fifth layer 48 may be disposed between the fourth layer 46 and the plug portion 53p.

In the second insulating structure Isb, the first layer 40b may be in contact with one side surface and a lower surface of the second layer 42b. In the second insulating structure Isb, the second layer 42b may be in contact with one side surface and a lower surface of the third layer 44. In the second insulating structure Isb, the fourth layer 46 may be in contact with one side surface and a lower surface of the fifth layer 48. In the second insulating structure Isb, lower surfaces of the first, second, fourth and fifth layers 40b, 42b, 46, and 48 may each be disposed at a level lower than a level of the lower surface of the third layer 44.

In the second insulating structure Isb, at least one of the first layer 40b or the fourth layer 46 may be formed of the first material, such as, for example, silicon carbonitride (SiCN), and at least one of the second layer 42b or the fifth layer 48 may be formed of the second material, such as, for example, silicon nitride (Si₃N₄).

In an example, the first layer 40b may be formed of the first material, such as, for example, silicon carbonitride (SiCN), and the second layer 42b may be formed of the second material, such as, for example, silicon nitride (Si₃N₄).

In another example, the first layer 40b may be formed of the second material, such as, for example silicon nitride (Si₃N₄), and the second layer 42b may be formed of the first material, such as, for example silicon carbonitride (SiCN).

In an example, in the second insulating structure ISb, the fourth layer 46 may be formed of the first material, such as, for example, silicon carbonitride (SiCN), and the fifth layer 48 may be formed of the second material, such as, for example, silicon nitride (Si₃N₄).

In another example, in the second insulating structure ISb, the fourth layer 46 may be formed of the second material, such as, for example, silicon nitride (Si₃N₄), and the fifth layer 48 may be formed of the first material, such as, for example silicon carbonitride (SiCN).

In an example, in the second insulating structure ISb, the third layer 44 may be formed of the third material, such as, for example, silicon oxide (SiOz).

In another example, in the second insulating structure Isb, the third layer 44 may be formed of the second material, such as, for example, silicon nitride (Si₃N₄).

In FIG. 1, the circles denoted by reference numeral 38 may represent the side surface of the insulating structure IS, and the internal region of each of the circles denoted by reference number 38 may represent a region in which the insulating structure IS is not formed. The portion denoted by reference numeral 38a in FIG. 1 may be the side surface of the first insulating structure Isa as in FIG. 2A, and the portion denoted by reference number 38b in FIG. 1 may be a side surface of the second insulating structure Isb as in FIG. 2B. Accordingly, the insulating structure IS may have a connected shape, and the insulating structure IS may include circular side surfaces spaced apart from each other.

In FIG. 1, the circles denoted by reference numeral 38 may not overlap the region of the active region 6a intersecting or overlapping the bit line structure BS, that is, for example, the first impurity region 9a, and may overlap the regions in the end portion of the active region 6a which does not overlap the bit line structure BS, that is, for example, the second impurity regions 9b. The first impurity region 9a may be a central portion of the active region 6a located between two adjacent gate structures GS, and the second impurity region 9b may be an end portion of the active region 6a located between two adjacent gate structures. In FIG. 1, a circle denoted by reference numeral 38 may overlap a portion of the contact structure 88.

In the bit line structure BS, the line portion 61 may include a first line portion 61a connected to the plug portion 53p and vertically overlapping the plug portion 53p, and a second line portion 61b extending from the first line portion 61a in the second direction Y.

A lower surface of the first line portion 61a may be in contact with the plug portion 53p. The first line portion 61a of the bit line structure BS may vertically overlap the active region 6a, and may not overlap the gate capping layer 18 and the isolation region 6s.

A lower surface of the second line portion 61b may be in contact with an upper surface of the buffer structure 35 and an upper surface of the second insulating structure Isb.

In the bit line structure BS, the line portion 61 may include a plurality of conductive layers. For example, the line portion 61 may include a first conductive layer 55, a second conductive layer 57, and a third conductive layer 59 stacked in order. The first conductive layer 55 may include doped polysilicon (p-Si), such as, for example, doped polysilicon (p-Si) having an N-type conductivity. The second conductive layer 57 may include at least one of a metal-semiconductor compound layer or a conductive barrier layer. For example, the metal-semiconductor compound layer may include at least one of tungsten silicide (WSi₂), titanium silicide (TiSi₂), tantalum silicide (TaSi₂), nickel silicide (NiSi₂) or cobalt silicide (CoSi₂), and the conductive barrier layer may include at least one of titanium nitride (TiN), tantalum nitride (TaN), tungsten nitride (WN), titanium silicon nitride (TiSiN), tantalum silicon nitride (TaSiN) or ruthenium titanium nitride (RuTiN). The third conductive layer 59 may include a metal material such as tungsten (W).

The semiconductor device 1 may further include a bit line capping pattern 64 having a side surface aligned with a side surface of the bit line structure BS on the bit line structure BS. The bit line capping pattern 64 may include an insulating material such as, for example, silicon nitride (Si₃N₄).

The semiconductor device 1 may further include a contact structure 88 disposed on the pad pattern 21. The contact structure 88 may be in contact with the pad pattern 21. The first insulating structure ISa may be in contact with the contact structure 88. For example, the first spacer SP1 of the first insulating structure ISa may be in contact with the contact structure 88. The contact structure 88 may be formed of a conductive material. For example, the contact structure 88 may include at least one of doped polysilicon (p-Si), a metal-semiconductor compound layer, a metal nitride, or a metal.

The semiconductor device 1 may further include bit line spacers 85 disposed on side surfaces of the bit line structure BS and the bit line capping pattern 64. At least a portion of the bit line spacer 85 may be disposed between the bit line structure BS and the contact structure 88. In an example, a portion of the bit line spacer 85 may be disposed between the second, third and fourth buffer layers 29, 31, and 33 of the buffer structure 35 and the contact structure 88.

In an example, the bit line spacer 85 may be in contact with the line portion 61 of the bit line structure BS, may extend downwardly and may cover the upper side surface of the plug portion 53p, and may be in contact with the first insulating structure Isa.

In another example, the bit line spacer 85 may be in contact with the line portion 61 of the bit line structure BS, may extend downwardly and may cover the side surfaces of the second, third and fourth buffer layers 29, 31, and 33, and may be in contact with the upper surface of the first buffer layer 27.

In an example, the bit line spacer 85 may include a silicon nitride (Si₃N₄) layer and a silicon oxide (SiOz) layer stacked in order from a side surface of the line portion 61. For example, the silicon nitride (Si₃N₄) layer of the bit line spacer 85 may be in contact with the line portion 61 of the bit line structure BS.

In an example, the bit line spacer 85 may include a silicon oxide (SiOz) layer and a silicon nitride (Si₃N₄) layer stacked in order on the side surface of the line portion 61.

In another example, the bit line spacer 85 may include a first silicon nitride (Si₃N₄) layer, a silicon oxide (SiOz) layer and a second silicon nitride (Si₃N₄) layer stacked in order on the side surface of the line portion 61.

In another example, the bit line spacer 85 may include an air gap. For example, the bit line spacer 85 may be formed as an air gap spacer.

The semiconductor device 1 may further include a landing pad 90 disposed on the contact structure 88 and an insulating isolation pattern 92 defining a side surface of the landing pad 90 and extending downwardly. The landing pad 90 may be electrically connected to the contact structure 88. The landing pad 90 may be formed of a conductive material. In an example, the landing pad 90 may be formed of a material that contains a metal such as, for example, tungsten (W), but the present disclosure is not limited thereto. The insulating isolation pattern 92 may extend from a portion in contact with a side surface of the landing pad 90 into a portion of the bit line capping pattern 64 and a portion of the contact structure 88. The insulating isolation pattern 92 may include silicon nitride (Si₃N₄). An upper surface of the insulating isolation pattern 92 may be coplanar with an upper surface of the landing pad 90.

The semiconductor device 1 may further include an insulating etch stop layer 94 disposed on the landing pad 90 and the insulating isolation pattern 92.

The semiconductor device 1 may further include a data storage structure 96.

In an example, the data storage structure 96 may be a capacitor structure for storing data in a memory, such as a dynamic random access memory (DRAM). For example, the data storage structure 96 may be configured as a capacitor structure including a first electrode 98a penetrating through the insulating etch stop layer 94 and in contact with the landing pad 90, a dielectric layer 98b covering the first electrode 98a on the insulating etch stop layer 94, and a second electrode 98c disposed on the dielectric layer 98b. The dielectric layer 98b may be interposed between the first electrode 98a and the second electrode 98c, and between the second electrode 98c and the insulating etch stop layer 94. The data storage structure 96 may be configured as a capacitor structure for storing data in a memory such as DRAM, but the present disclosure is not limited thereto, and the data storage structure 96 may be a structure for storing data in a memory other than DRAM.

In the above-described example embodiment, the plug portion 53p may be referred to as a first conductive region, and the pad pattern 21 or the second impurity region 9b may be referred to as a second conductive region. Accordingly, the above-described semiconductor device 1 may include the first insulating structure Isa having a first side and a second side opposing each other, the first conductive region 53p disposed on the first side of the first insulating structure Isa, and the second conductive region 21 or 9b disposed on the second side of the first insulating structure Isa. The first spacer SP1 may be in contact with the second conductive region 21 or 9b and may include a first material. The insulating pattern 76 may be disposed between the first conductive region 53p and the first spacer SP1 and may include a second material different from the first material. The insulating liner 73 may cover a side surface and a bottom surface of the insulating pattern 76 and may include a third material different from the first and second materials.

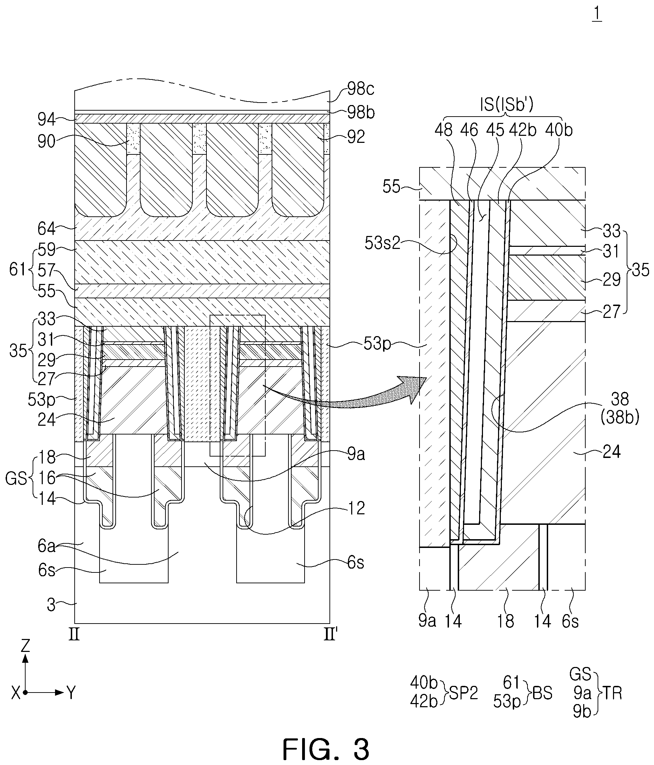

Hereinafter, various modified examples of the components of the above-described semiconductor device 1 will be described with reference to FIGS. 3, 4A and 4B, 5A and 5B, and 6. Various modified examples of the components of the above-described semiconductor device 1 described below will be mainly described with respect to the components to be modified or the components to be replaced. Also, the components which may be modified or replaced will be described below with reference to each drawing, and the components which may be modified may be combined with each other or may be combined with the components described above and may be included in the semiconductor device 1 according to an example embodiment of the present disclosure.

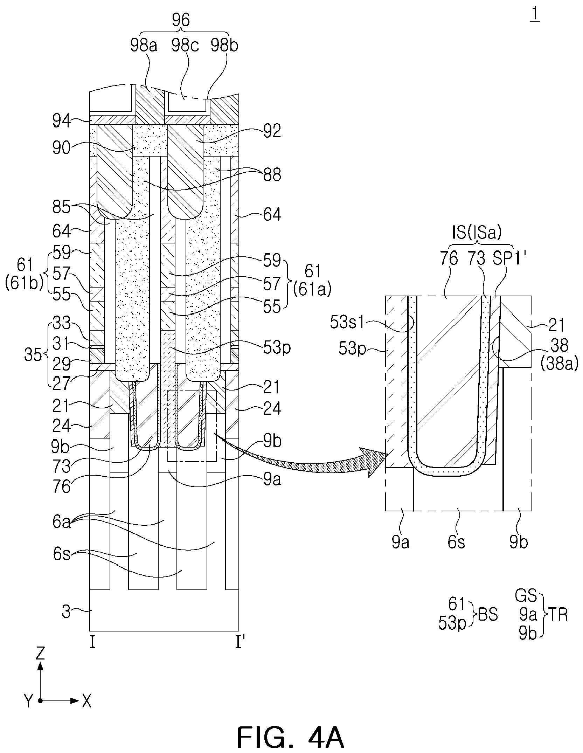

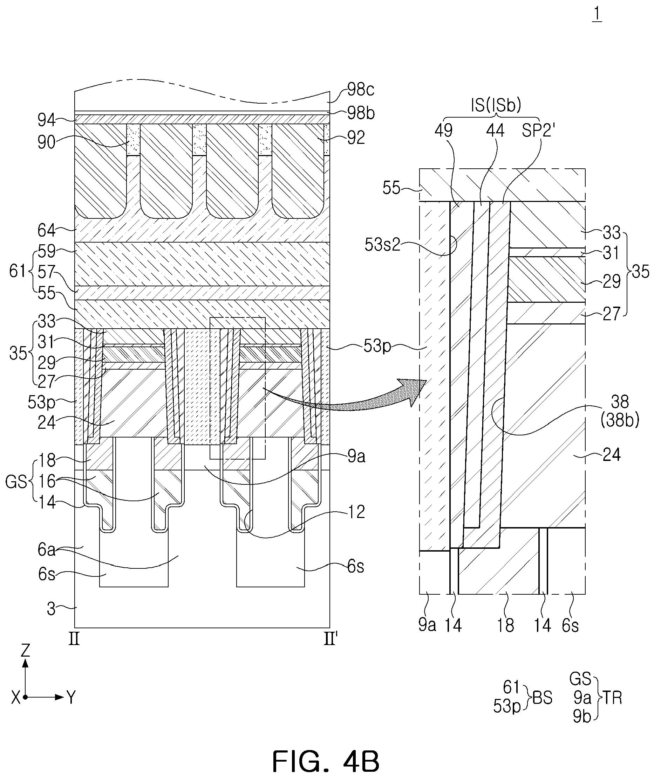

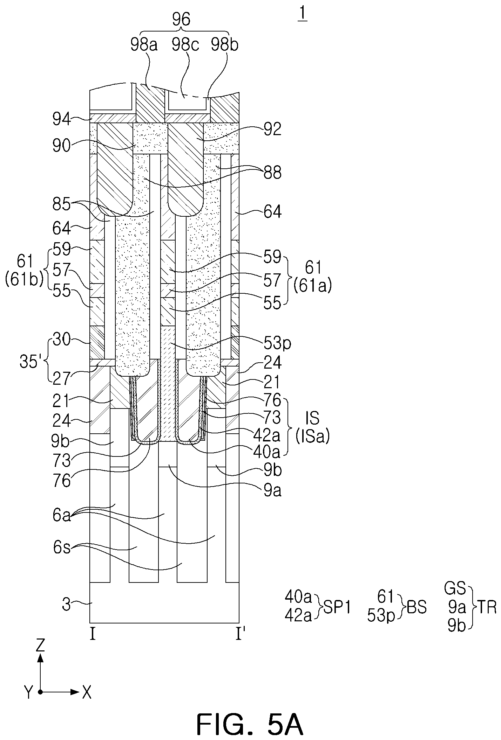

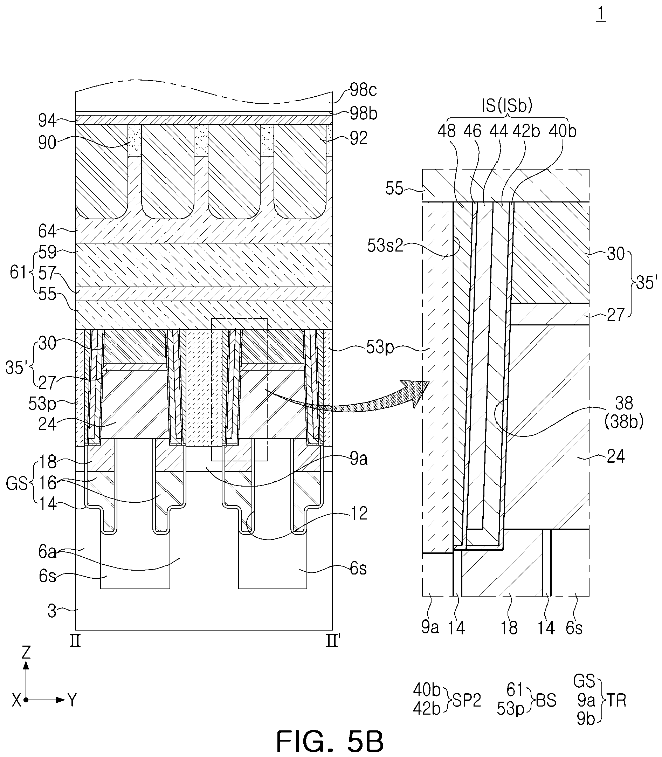

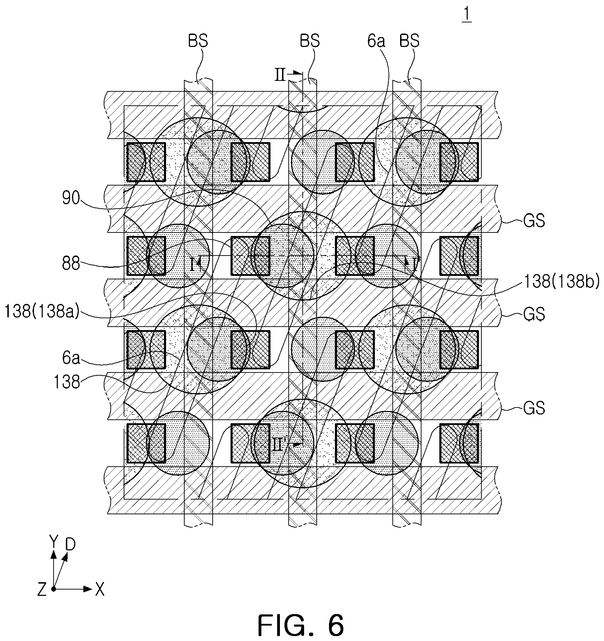

In FIGS. 3, 4A and 4B, 5A and 5B, and 6, FIGS. 4A and 5A are cross-sectional diagrams illustrating a region taken along line I-I' in FIG. 1, and FIGS. 3, 4B and 5B are cross-sectional diagrams illustrating a region taken along line II-II' in FIG. 1. In FIGS. 3, 4A and 4B, 5A and 5B, and 6, FIG. 3 is a cross-sectional diagram illustrating a modified example in the cross-sectional structure as in FIG. 2B, FIGS. 4A and 4B are cross-sectional diagrams illustrating a modified example in the cross-sectional structure in FIGS. 2A and 2B, FIGS. 5A and 5B are cross-sectional diagrams illustrating a modified example in the cross-sectional structure in FIGS. 2A and 2B, and FIG. 6 is a diagram illustrating a modified example as in FIG. 1, viewed from above.

In a modified example, referring to FIG. 3, the above-described second insulating structure Isb (in FIG. 2B) may be modified into a second insulating structure Isb' including an air gap 45. The air gap 45 of the second insulating structure Isb' may replace the third layer 44 (in FIG. 2B) of the second insulating structure Isb (in FIG. 2B) described above. For example, the third layer 44 (in FIG. 2B) may be removed to form the air gap 45 (in FIG. 3). Accordingly, the second insulating structure Isb' may include the first, second, fourth and fifth layers 40b, 42b, 46, and 48 in FIG. 2B, together with the air gap 45. The second insulating structure Isb' may include the air gap 45, the fourth layer 46, and the fifth layer 48 included in the third spacer 45, 46, and 48 together with the second spacer SP2.

In a modified example, referring to FIGS. 4A and 4B, the first spacer SP1 (in FIG. 2A) of the first insulating structure Isa (in FIG. 2A) in FIG. 2A may be replaced with the first spacer SP1' formed in a single layer as in FIG. 4A. The second spacer SP2 (in FIG. 2B) of the second insulating structure Isb (in FIG. 2B) in FIG. 2B may be replaced with a second spacer SP2' formed in a single layer as in FIG. 4B.

In an example, the fourth and fifth layers 46 and 48 (in FIG. 2B) of the second insulating structure Isb (in FIG. 2B) in FIG. 2B may be replaced with a third spacer 49 formed in a single layer. For example, two layers of the first and second layers 40a and 42a (in FIG. 2A) may be replaced with a single layer of the first spacer SP1' (in FIG. 4A), two layers of the first and second layers 40b and 42b (in FIG. 2B) may be replaced with a single layer of the second spacer SP2' (in FIG. 4B), and two layers of the fourth and fifth layers 46 and 48 (in FIG. 2B) may be replaced with a single layer of the third spacer 49 (in FIG. 4B).

Each of the first, second and third spacers SP1', SP2', and 49 may be formed as a single silicon carbonitride (SiCN) layer.

In a modified example, referring to FIGS. 5A and 5B, in the buffer structure 35 (in FIGS. 2A and 2B) in FIGS. 2A and 2B described above, the second to fourth buffer layers 29, 31, and 33 (in FIGS. 2A and 2B) may be replaced with a buffer layer 30 (in FIGS. 5A and 5B). Accordingly, the buffer structure 35 (in FIGS. 2A and 2B) described above may be modified to a buffer structure 35' (in FIGS. 5A and 5B) in which the second to fourth buffer layers 29, 31, and 33 (in FIGS. 2A and 2B) are replaced with a single insulating layer 30 (in FIGS. 5A and 5B). In the buffer structure 35', the insulating layer 30 may be referred to as a second buffer layer. Accordingly, the buffer structure 35' may include the second buffer layer 30 (in FIGS. 5A and 5B) together with the first buffer layer 27 (in FIGS. 2A, 2B, 5A and 5B) described with reference to FIGS. 2A and 2B. The second buffer layer 30 may be formed of silicon nitride (Si₃N₄), and the first buffer layer 27 may be a silicon oxide (SiOz) layer or a silicon oxide (SiOz)-based insulating material layer.

In a modified example, referring to FIG. 6, the circles denoted by reference numeral 38 in FIG. 1 may not intersect the region of the active region 6a intersecting or overlapping the bit line structure BS, that is, for example, the first impurity region 9a, and may overlap the regions in the end portion of the active region 6a which does not overlap the bit line structure BS, that is, for example, the second impurity regions 9b as described above. The circles denoted by reference numeral 38 in FIG. 1 may be modified to circles denoted by reference numeral 138 in FIG. 6 which overlap the region of the active region 6a intersecting or overlapping the bit line structure BS, that is, for example, the first impurity region 9a. A circle denoted by reference numeral 138 in FIG. 6 may partially overlap the contact structure 88 disposed in the region of the active region 6a in the first direction X, which intersect or overlap the bit line structure BS. For example, in FIG. 1, the circle denoted by reference numeral 38 may overlap the region in the end portion of the active region 6a which does not overlap the bit line structure BS, while in FIG. 6, the circle denoted by reference numeral 138 may overlap the region in the central portion of the active region 6a which intersects or overlaps the bit line structure BS.

In FIG. 1, the circles denoted by reference numeral 38 may represent the side surface of the insulating structure IS, and the internal region of each of the circles denoted by reference numeral 38 may represent the region in which the insulating structure IS is not formed.

FIG. 2A may illustrate a cross-sectional structure of a region taken along line I-I' in FIG. 6, and FIG. 2B may illustrate a cross-sectional structure of a region taken along line II-II' in FIG. 6.

In FIG. 6, the circles denoted by reference numeral 138 may represent the side surface of the insulating structure IS (in FIGS. 2A and 2B), and the insulating structure IS and the plug portion (53p in FIGS. 2A and 2B) may be disposed in the internal region of each of the circles denoted by reference numeral 138. Accordingly, a plurality of the insulating structures IS (in FIGS. 2A and 2B) may be disposed to be spaced apart from each other. For example, each of the plurality of insulating structures IS (in FIGS. 2A and 2B) may overlap a single active region 6a. In one example, the portion denoted by reference numeral 138a in FIG. 6 may be the side surface of the first insulating structure Isa as in FIG. 2A, and the portion denoted by reference number 138b in FIG. 6 may be a side surface of the second insulating structure Isb as in FIG. 2B.

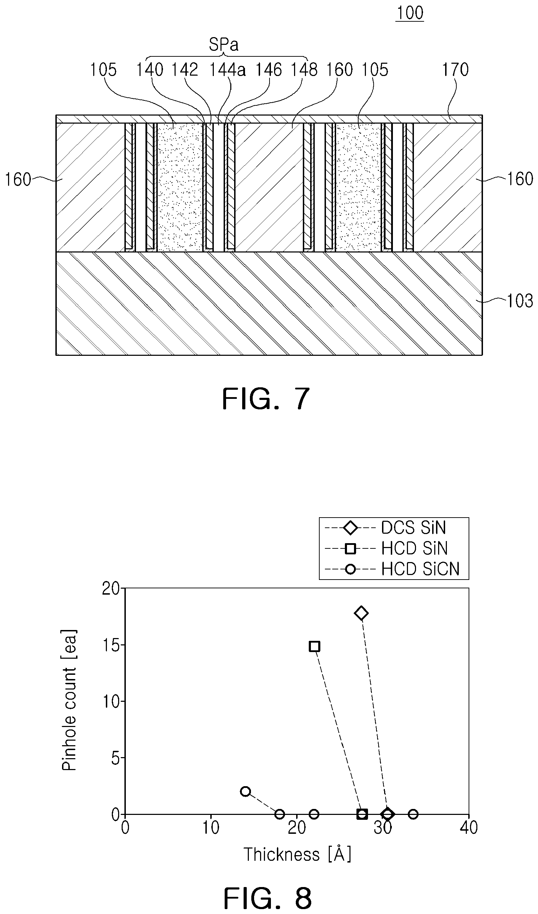

In the description below, a semiconductor device 100 according to a modified example embodiment of the present disclosure will be described with reference to FIG. 7.

Referring to FIG. 7, the semiconductor device 100 in the modified example embodiment may include a lower structure 103, a conductive structure 105 on the lower structure 103, an insulating structure 160 on a side surface of the conductive structure 105, a spacer structure SPa disposed between the conductive structure 105 and the insulating structure 160, and a capping insulating layer 170 covering the conductive structure 105, the insulating structure 160, and the spacer structure Spa.

The spacer structure SPa may include an air gap 144a, internal spacers 140 and 142 disposed between the air gap 144a and the conductive structure 105, and external spacers 146 and 148 disposed between the air gap 144a and the insulating structure 160.

The internal spacers 140 and 142 may include a silicon carbonitride (SiCN) material layer. The external spacers 146 and 148 may include a silicon carbonitride (SiCN) material layer.

The internal spacers 140, 142 may be a single layer or multiple layers. The external spacers 146 and 148 may be a single layer or multiple layers.

When the internal spacers 140 and 142 are a single layer, the internal spacers 140 and 142 may be formed as a silicon carbonitride (SiCN) material layer. When the external spacers 146 and 148 are a single layer, the external spacers 146 and 148 may be formed as a silicon carbonitride (SiCN) material layer.

When the internal spacers 140 and 142 are multiple layers, the internal spacers 140 and 142 may include a first layer 140 disposed between the conductive structure 105 and the air gap 144a, and a second layer 142 disposed between the first layer 140 and the air gap 144a. The first layer 140 may cover a lower surface of the second layer 142.

When the external spacers 146 and 148 are multiple layers, the external spacers 146 and 148 include a third layer 146 disposed between the air gap 144a and the insulating structure 160, and a fourth layer 148 disposed between the third layer 146 and the insulating structure 160. The third layer 146 may cover a lower surface of the fourth layer 148.

In an example, the first layer 140 may be a silicon carbonitride (SiCN) layer, and the second layer 142 may be a silicon nitride (Si₃N₄) layer.

In another example, the first layer 140 may be a silicon nitride (Si₃N₄) layer, and the second layer 142 may be a silicon carbonitride (SiCN) layer.

In an example, the third layer 146 may be a silicon carbonitride (SiCN) layer, and the fourth layer 148 may be a silicon nitride (Si₃N₄) layer.

In another example, the third layer 146 may be a silicon nitride (Si₃N₄) layer, and the fourth layer 148 may be a silicon carbonitride (SiCN) layer.

In the description described with reference to FIGS. 1, 2A and 2B, silicon carbonitride (SiCN) of the first material may be formed using a hexa-chlorodi-silane (HCD, Si₂Cl₆) precursor, and silicon nitride (Si₃N₄) of the second material may be formed using a hexa-chlorodi-silane (HCD, Si₂Cl₆), di-chlorosilane (DCS, SiH₂Cl₂), silane (SiH₄), disilyne (Si₂H₂), diiodosilane (SiH₂I₂), or diisopropylaminosilane (DIPAS) and a precursor. Hereinafter, a silicon carbonitride (SiCN) material formed using a hexa-chlorodi-silane (HCD, Si₂Cl₆) precursor, a silicon nitride (Si₃N₄) material formed using a hexa-chlorodi-silane (HCD, Si₂Cl₆), and a silicon nitride (Si₃N₄) material formed using di-chlorosilane (DCS, SiHzCh) will be described with reference to FIG. 8.

Referring to FIG. 8, in the graph in FIG. 8, HCD SiCN may be a silicon carbonitride (SiCN) material formed on a silicon oxide (SiOz) layer using a hexa-chlorodi-silane (HCD, Si₂Cl₆) precursor, HCD SiN may be a silicon nitride (Si₃N₄) material formed on a silicon oxide (SiOz) layer using a hexa-chlorodi-silane (HCD, Si₂Cl₆), and DCS SiN may be a silicon nitride (Si₃N₄) material formed on a silicon oxide (SiOz) layer using di-chlorosilane (DCS, SiH₂Cl₂). In the graph in FIG. 8, the horizontal axis may represent the thickness, and the vertical axis may represent the number of pinholes. The number of pinholes in the graph in FIG. 8 may represent a tendency of the number of pinholes of HCD SiCN, HCD SiN, and DCS SiN. In the graph in FIG. 8, the number of pinholes may not be an absolute number. For example, the number of pinholes may vary depending on process conditions such as process pressure or process temperature.

In the graph in FIG. 8, it is indicated that HCD SiCN may have two pinholes at a thickness of about 14 Å, there may be no pinholes at a thickness of about 18 Å, HCD SiN may have 15 pinholes at a thickness of about 22 Å, there may be no pinhole at a thickness of about 27.5 Å, DCS SiN may have 18 pinholes at a thickness of about 27.5 Å, and there may be no pinhole at a thickness of about 30 Å. In other words, with the decrease in thickness, the number of pinholes may increase. For example, based on the graph in FIG. 8, to have no pinholes, HCD SiCN may require a thickness of about 18 Å or greater, HCD SiN may require a thickness of about 27.5 Å or greater, and DCS SiN may require a thickness of about 30 Å or greater.

According to the above results, it is indicated that HCD SiCN may be the smallest number of pinholes and may be the most stable among HCD SiCN, HCD SiN, and DCS SiN formed on the silicon oxide (SiOz) layer at a thickness of about 22 Å or less. Based on the results shown in FIG. 8, HCD SiCN having a thickness of about 22 Å (which is greater than 18 Å) may not have pinholes, while HCD SiN having a thickness of about 22 Å (which is smaller than 27.5 Å) or DCS SiN having a thickness of about 22 Å (which is smaller than 30 Å) may have pinholes.

According to the above results, when HCD SiCN, HCD SiN, and DCS SiN in contact with the silicon oxide (SiOz) layer are formed, and the silicon oxide (SiOz) layer is removed by an etching process, HCD SiCN having the smallest number of pinholes may be the least affected by the etching process of etching the oxide layer.

Also, according to these results, HCD SiCN, which has the smallest number of pinholes, may hardly react with the silicon oxide (SiOz) layer at a thickness of about 22 Å or less, such that a transition layer may be hardly formed, whereas HCD SiN and DCS SiN, which have a relatively large number of pinholes, may react with the silicon oxide (SiOz) layer such that a transition layer such as the silicon oxynitride (SiON) layer may be formed. The absence of such a transition layer may indicate that even when the HCD SiCN is formed on the silicon oxide (SiOz) layer, there may be almost no loss in the thickness of the HCD SiCN layer.

When the HCD SiN layer or DCS SiN layer is formed on the silicon oxide (SiOz) layer to have a thickness of about 22 Å, the HCD SiN or DCS SiN may react with the silicon oxide (SiOz) layer such that a transition layer of silicon oxynitride (SiON) may be formed, and the thickness of the HCD SiN layer or DCS SiN layer having a thickness of about 22 Å may decrease to be less than 22 Å, and the HCD SiN layer having a reduced thickness may not be able to work as a barrier against the etching process to remove silicon oxide (SiOz).

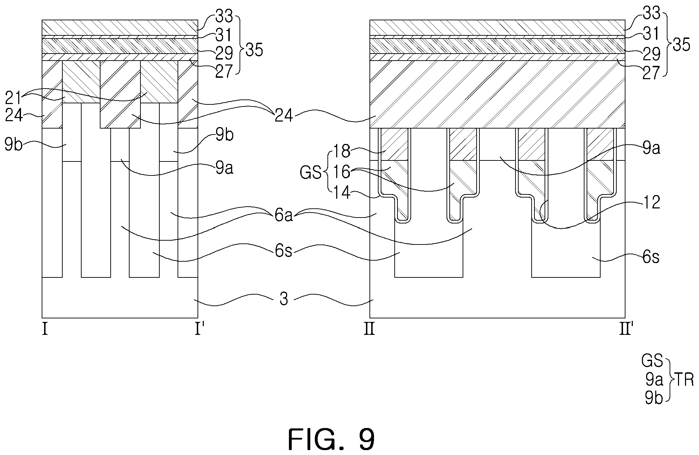

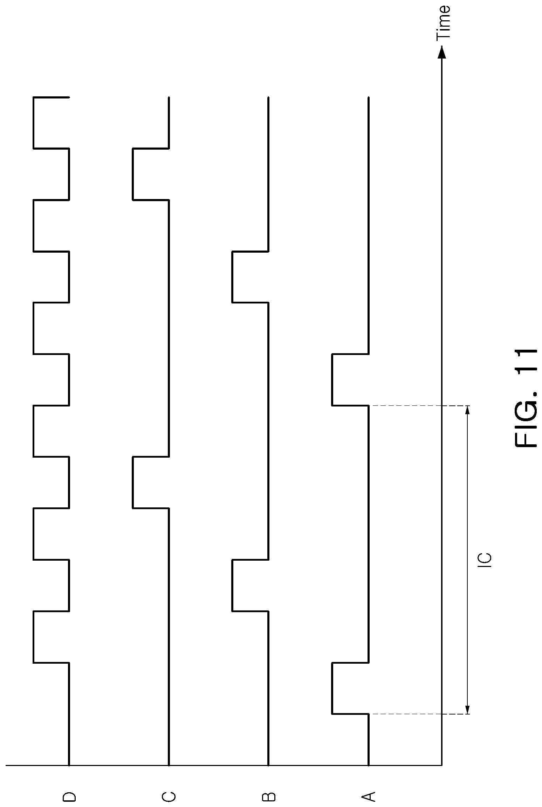

A method of forming a semiconductor device using HCD SiCN as described above will be described with reference to FIGS. 1 and 9 to 17. FIGS. 9, 10, and 12 to 17 are cross-sectional diagrams illustrating regions taken along lines I-I' and II-II' in FIG. 1, and FIG. 11 is a diagram illustrating supply of gases to form a silicon carbonitride (SiCN) material in the example of the method of forming a semiconductor device according to an example embodiment of the present disclosure.

Referring to FIGS. 1 and 9, the isolation region 6s defining the active region 6a may be formed on the substrate 3. The isolation region 6s may be formed on a side surface of the active region 6a. The isolation region 6s may be formed of an insulating material such as, for example, silicon oxide (SiOz) and/or silicon nitride (Si₃N₄). The substrate 3 may be a semiconductor substrate. For example, the substrate 3 may be a single crystal silicon (sc-Si) substrate. The active region 6a may protrude from the substrate 3 and may be formed of single crystal silicon (sc-Si).

A transistor TR may be formed on the substrate 3. The forming of the transistor TR may include forming a gate trench 12 intersecting the active region 6a and extending into the isolation region 6s, and forming a gate structure GS in the gate trench 12.

The gate structure GS may include a gate dielectric layer 14 conformally covering an internal wall of the gate trench 12, a gate electrode 16 partially filling the gate trench 12 on the gate dielectric layer 14, and a gate capping layer 18 filling the other portion of the gate trench 12 on the gate electrode 16. The gate dielectric layer 14 may include silicon oxide (SiOz) and/or a high-k dielectric. The gate electrode 16 may include a doped polysilicon (p-Si), a metal, a conductive metal nitride, a metal-semiconductor compound, a conductive metal oxide, graphene, carbon nanotube, or a combination thereof. The gate capping layer 18 may be formed of an insulating material, such as, for example, silicon nitride (Si₃N₄).

The forming of the transistor TR may further include forming the first and second impurity regions 9a and 9b in the active region 6a through an ion implantation process. The first and second impurity regions 9a and 9b may be sources/drains.

In an example, the first and second impurity regions 9a and 9b may be formed by implanting impurities into the active region 6a before the isolation region 6s is formed.

In another example, the first and second impurity regions 9a and 9b may be formed after the isolation region 6s is formed and before the gate trench 12 is formed.

In another example, the first and second impurity regions 9a and 9b may be formed after the gate structure GS is formed.

The active regions 6a may have P-type conductivity, and the first and second impurity regions 9a and 9b may have N-type conductivity. For example, the active regions 6a may be doped, for example, through an ion implantation process, with a P-type dopant. The P-type dopants (or impurities) may include, for example, boron (B), aluminum (Al), gallium (Ga), etc. The first and second impurity regions 9a and 9b may be doped with an N-type dopant. The N-type dopants (or impurities) may include, for example, phosphorus (P), arsenic (As), etc.

A pad pattern 21 may be formed on the substrate 3 having the cell transistor TR. The pad pattern 21 may cover the transistor TR and the isolation region 6s.

The pad pattern 21 may be formed of a silicon (Si) layer, such as, for example, a doped polysilicon (p-Si) layer. The pad pattern 21 may have a conductivity type the same as that of the first and second impurity regions 9a and 9b, such as, for example, N-type conductivity.

An insulating barrier pattern 24 penetrating through the pad pattern 21 and having a lower surface disposed at a level lower than a level of the lower surface of the pad pattern 21 may be formed. The insulating barrier pattern 24 may be in contact with a portion of a side surface of the pad pattern 21. The pad pattern 21 may be in contact with the second impurity region 9b. The insulating barrier pattern 24 may be formed of silicon nitride (Si₃N₄).

A buffer structure 35 may be formed on the pad pattern 21 and the insulating barrier pattern 24.

The buffer structure 35 may include a plurality of buffer layers stacked in order. For example, the buffer structure 35 may include a first buffer layer 27, a second buffer layer 29, a third buffer layer 31, and a fourth buffer layer 33 sequentially stacked on the pad pattern 21 and the insulating barrier pattern 24.

A thickness of each of the second buffer layer 29 and the fourth buffer layer 33 may be greater than a thickness of each of the first buffer layer 27 and the third buffer layer 31.

The second buffer layer 29 may be formed of a material having etch selectivity with respect to the materials of the first buffer layer 27 and the third buffer layer 31. The fourth buffer layer 33 may be formed of a material having etch selectivity with respect to the materials of the first to third buffer layers 27, 29, and 31. The first buffer layer 27 may be formed of silicon oxide (SiOz) or a silicon oxide (SiOz)-based insulating material. The second buffer layer 29 may be formed of silicon nitride (Si₃N₄) or a silicon nitride (Si₃N₄)-based insulating material. The third buffer layer 31 may be formed of silicon oxide (SiOz) or a silicon oxide (SiOz)-based insulating material. The fourth buffer layer 33 may be formed as a conductive layer. For example, the fourth buffer layer 33 may be formed as a doped silicon (Si) layer or a conductive material layer which may replace the doped silicon (Si) layer. The fourth buffer layer 33 may be formed as a doped polysilicon (p-Si) layer having N-type conductivity.

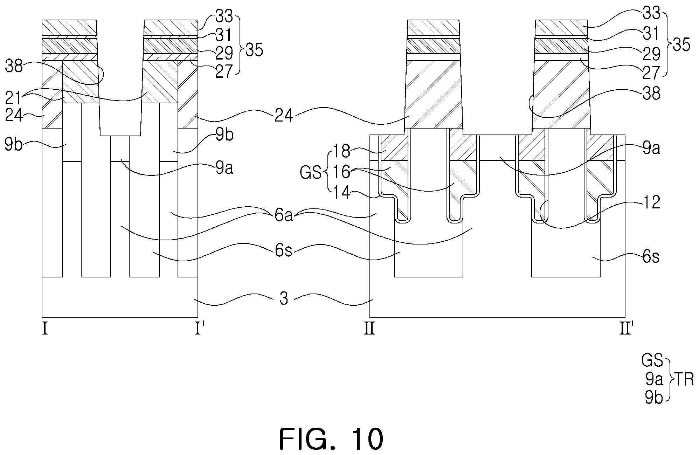

Referring to FIGS. 1 and 10, an opening 38 penetrating through the buffer structure 35 and extending downwardly may be formed. The opening 38 may have a lower surface disposed at a level lower than a level of the lower surface of the pad pattern 21. The opening 38 may penetrate through at least the insulating barrier pattern 24 and may expose the first impurity region 9a. The sidewall of the opening 38 may be defined as the sidewall of the insulating structure IS described in the aforementioned example embodiment with reference to FIGS. 1, 2A and 2B.

Referring to FIGS. 1, 11 and 12, spacer structures 40, 42, 44, 46, and 48 covering sidewalls of the opening 38 may be formed.

The forming of the spacer structures 40, 42, 44, 46, and 48 may include conformally forming a first layer 40 in the opening 38 to cover sidewall surfaces and a bottom surface of the opening 38, conformally forming a second layer 42 on the first layer 40, conformally forming a third layer 44 on the second layer 42, anisotropically etching the first to third layers 40, 42, and 44 by an anisotropic etching process to expose the first impurity region 9a, conformally forming a fourth layer 46, conformally forming a fifth layer 48 on the fourth layer 46, and anisotropically etching the fourth and fifth layers 46 and 48 by an anisotropic etching process to expose the first impurity region 9a.

The sum of the thicknesses of the first and second layers 40 and 42 may be in the range of about 20 Å to about 30 Å in thickness.

In an example, the first layer 40 may be formed of a silicon carbonitride (SiCN) material, and the second layer 42 may be formed of a silicon nitride (Si₃N₄) material. The first layer 40 may be formed to have a thickness less than that of the second layer 42.

In another example, the first layer 40 may be formed of a silicon nitride (Si₃N₄) material, and the second layer 42 may be formed of a silicon carbonitride (SiCN) material.

In another example, the first layer 40 and the second layer 42 may be formed of a silicon carbonitride (SiCN) material and may be formed as an integrated single layer.

The third layer 44 may be formed of silicon oxide (SiOz).

In an example, the fourth layer 46 may be formed of a silicon carbonitride (SiCN) material, and the fifth layer 48 may be formed of a silicon nitride (Si₃N₄) material. In another example, the fourth layer 46 may be formed of a silicon nitride (Si₃N₄) material, and the fifth layer 48 may be formed of a silicon carbonitride (SiCN) material.

Here, the silicon carbonitride (SiCN) material may be HCD SiCN which is a silicon carbonitride (SiCN) material formed on a silicon oxide (SiOz) layer using a hexa-chlorodi-silane (HCD, Si₂Cl₆) precursor as described in the aforementioned example embodiment with reference to FIG. 8. The silicon carbonitride (SiCN) material may be formed using a first gas A, a second gas B, a third gas C, and a purge gas D as illustrated in FIG. 11. For example, supplying the first gas A, the purge gas D, the second gas B, the purge gas D, the third gas C and the purge gas D to the substrate 3 formed up to the opening 38 may include repeatedly performing a deposition process of one cycle 1C until a desired thickness is formed. Here, the desired thickness may be a thickness of a layer formed of silicon carbonitride (SiCN).

The first gas A may be a silicon (C) source gas, such as, for example, hexa-chlorodi-silane (HCD, Si₂Cl₆), and the second gas B may be a carbon (C) source gas, such as, for example, one of ethylene (C₂H₄), cyclopropane (C₃H₆), and acetylene (C₂H₂). The third gas C may be a nitrogen (N) source gas, such as, for example, ammonia (NH₃) gas. The purge gas D may be nitrogen (N₂) gas or argon (Ar) gas.

After forming the HCD SiCN, silicon nitride (Si₃N₄) may be formed by a plasma deposition process or a thermal deposition process. When silicon nitride (Si₃N₄) is formed by a plasma deposition process after forming the HCD SiCN, a silicon nitride (Si₃N₄) layer may be formed by a thermal deposition process to protect the HCD SiCN layer, and a silicon nitride (Si₃N₄) layer may be formed by a plasma deposition process layer, after the HCD SiCN is formed. For example, the first layer 40 may be formed of HCD SiCN, and the second layer 42 may be formed of silicon nitride (Si₃N₄). Accordingly, the second layer 42 may include silicon nitride (Si₃N₄) by a thermal evaporation process and silicon nitride (Si₃N₄) by a plasma deposition process.

At least one of the first layer 40 in contact with the first buffer layer 27, which may be formed of silicon oxide (SiOz), or the second layer 42 in contact with the third layer 44, which may be formed of silicon oxide (SiOz), may be formed of HCD SiCN described in the aforementioned example embodiment with reference to FIG. 8.

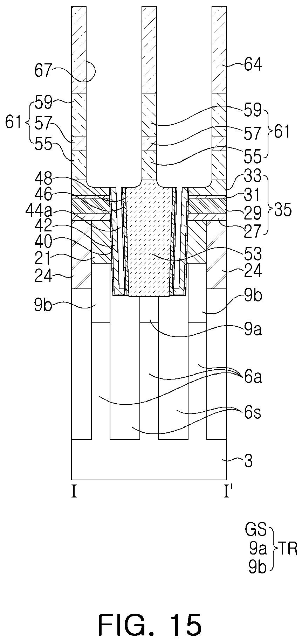

Here, by forming at least one of the first layer 40 or the second layer 42 using HCD SiCN, the first and second layers 40 and 42 may protect the first buffer layer 27 from the process of etching silicon oxide (SiOz) to remove the third layer 44, which will be described later in FIG. 15.

A plug layer 53 filling the opening 38 may be formed. The spacer structures 40, 42, 44, 46, and 48 may be interposed between a sidewall of the opening 38 and a sidewall of the plug layer 53. The plug layer 53 may be formed of a conductive material. For example, the plug layer 53 may be formed of a doped silicon (Si) layer, such as, for example, a polysilicon (p-Si) layer having N-type conductivity.

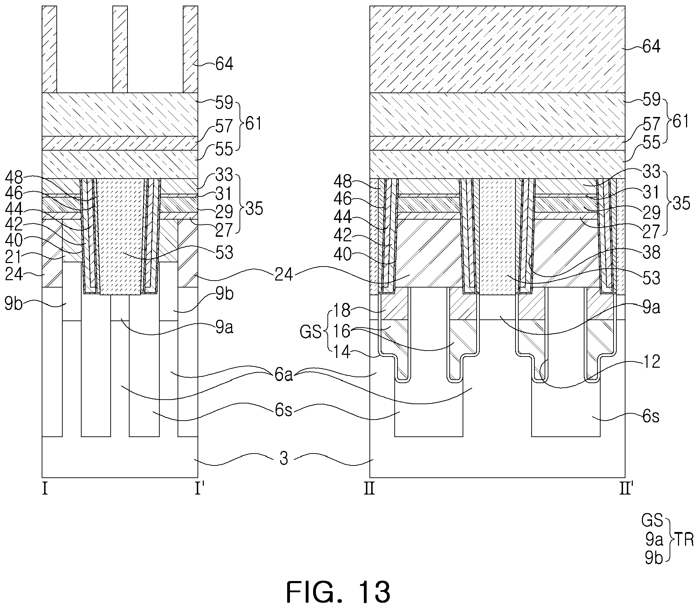

Referring to FIGS. 1 and 13, conductive layers 55, 57, and 59 stacked in order on the buffer structure 35, the spacer structures 40, 42, 44, 46, and 48, and the plug layer 53 may be formed. The conductive layers 55, 57, and 59 may include a first conductive layer 55, a second conductive layer 57, and a third conductive layer 59 stacked in order. The first conductive layer 55 may include doped polysilicon (p-Si), such as, for example, doped polysilicon (p-Si) having an N-type conductivity. The second conductive layer 57 may include at least one of a metal-semiconductor compound layer or a metal nitride. The third conductive layer 59 may include a metal material such as, for example, tungsten (W). A bit line capping pattern 64 may be formed on the conductive layers 55, 57, and 59. The bit line capping pattern 64 may be formed of silicon nitride (Si₃N₄).

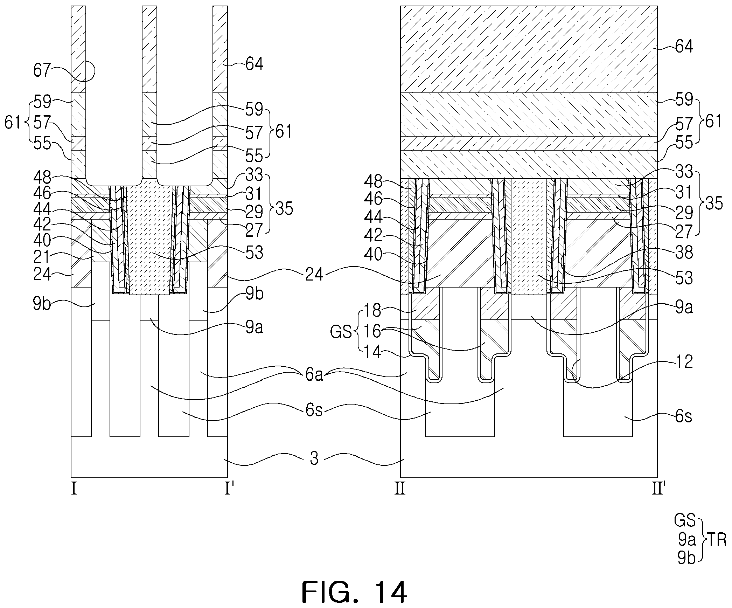

Referring to FIGS. 1 and 14, by performing an etching process using the bit line capping pattern 64 as an etch mask, the conductive layers 55, 57, 59 may be etched such that a line portion 61 may be formed, and also, an opening 67 exposing the spacer structures 40, 42, 44, 46 and 48 may be formed.

Referring to FIGS. 1 and 15, the opening 44a may be formed by selectively removing the third layer 44 among the spacer structures 40, 42, 44, 46 and 48.

In an example embodiment of the present disclosure, the third layer 44 may be formed of silicon oxide (SiOz), and the first and third buffer layers 27 and 31 may be formed of silicon oxide (SiOz).

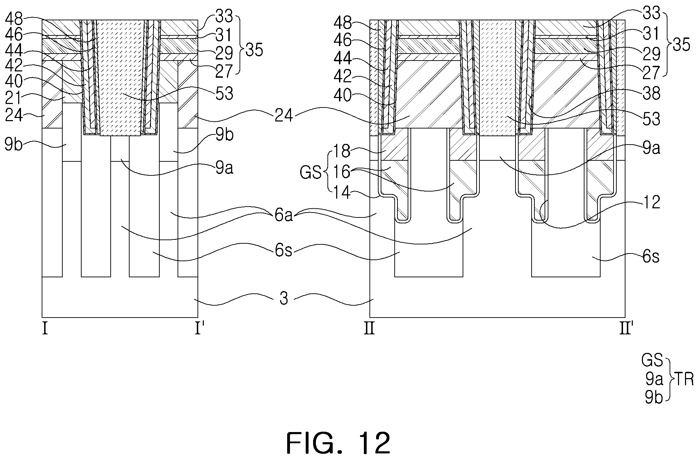

As described with reference to FIGS. 11 and 12, by forming at least one of the first layer 40 or the second layer 42 using HCD SiCN, the first and second layers 40 and 42 may protect the first and third buffer layers 27 and 31 from the process of etching silicon oxide (SiOz) to remove the third layer 44. As the first and second layers 40 and 42 protect the first and third buffer layers 27 and 31 from the process of etching silicon oxide (SiOz) to remove the third layer 44, defects caused by etching the first and third buffer layers 27 and 31 by the process of etching silicon oxide (SiOz) to remove the third layer 44, that is, for example, the defect in which the line portion 61 collapses, may be prevented.

In an example embodiment of the present disclosure, by forming the first spacer SP1, which is in contact with the first and third buffer layers 27 and 31 formed of silicon oxide (SiOz), as a silicon carbonitride (SiCN) layer instead of a silicon nitride layer (Si₃N₄), a transition layer such as a silicon oxynitride (SiON) layer may be prevented from being formed between the first spacer SP1 and silicon oxide (SiOz) of the first and third buffer layers 27 and 31. If a transition layer is formed, it has high etch selectivity with respect to silicon oxide (SiOz) in the process of removing silicon oxide (SiOz), and thus, may be easily etched during the corresponding etch process resulting in the formation of pinholes. Accordingly, the first spacer SP1 may be ruptured by the pinholes and defects may occur due to the first and third buffer layers 27 and 31 disposed below the line portion 61 may be partially etched during an oxide etch such that the line portion 61 may collapse.

When the third layer 44 is removed by an anisotropic etching process, the third layer 44 disposed below the line portion 61 may remain.

When the third layer 44 is removed by an isotropic etching process, the third layer 44 disposed below the line portion 61 may be removed, and an empty space in the lower portion of the line portion 61, formed while the third layer 44 is removed, that is, for example, an air gap may be formed.

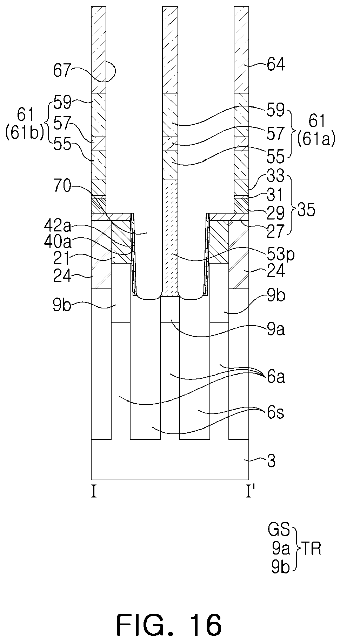

Referring to FIGS. 1 and 16, a plug portion 53p may be formed by anisotropically etching the plug layer 53. Accordingly, the bit line structure BS (in FIGS. 1, 2A and 2B) including the line portion 61 including the first and second line portions 61a and 61b (in FIG. 2A) as described with reference to FIGS. 1, 2A and 2B and the plug portion 53p may be formed.

During the anisotropic etching of the plug layer 53 to form the plug portion 53p, a portion of the spacer structures 40, 42, 44, 46, and 48 may be etched. Accordingly, an opening 70 may be formed on a side surface of the plug portion 53p, and the first and second layers 40 and 42 of the spacer structures 40, 42, 44, 46 and 48 may remain on the sidewall of the opening 70. Here, the first and second layers 40 and 42 remaining on the sidewall of the opening 70 may be denoted by 40a and 42a. The second layer 42 exposed by the opening 70 may be a second layer 42a having a reduced thickness. Here, the first and second layers 40a and 42a of the first insulating structure Isa (in FIG. 2A) in FIG. 2A may be formed.

In an example embodiment of the present disclosure, the sum of the thicknesses of the first and second layers 40a and 42a remaining on the sidewall of the opening 70 may be in the range from about 3 Å to about 10 Å.

In the etching process for forming the plug portion 53p, the second to fourth buffer layers 29, 31, 33 of the buffer structure 35 may be etched, and the first buffer layer 27 may be exposed.

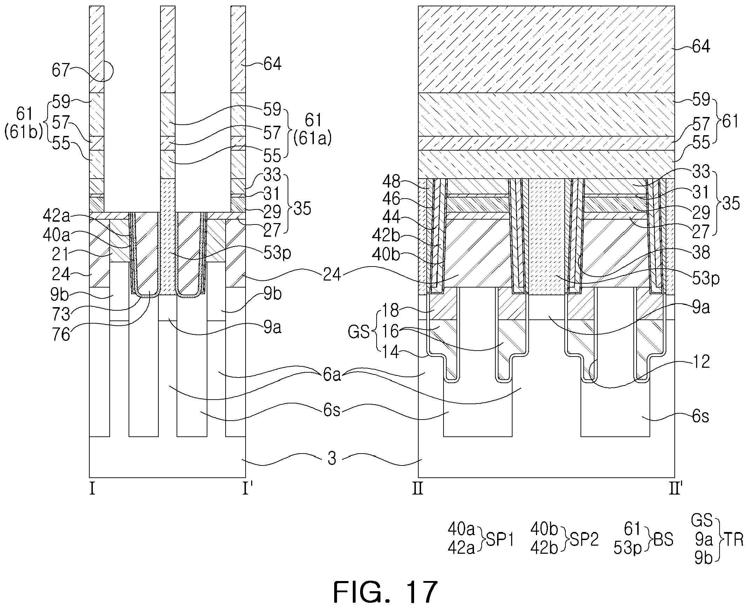

Referring to FIGS. 1 and 17, material layers 73 and 76 filling the opening 70 may be formed. The material layers 73 and 76 may include an insulating liner 73 covering the internal wall of the opening 70 and an insulating pattern 76 filling the opening 70 on the insulating liner 73. Here, the insulating liner 73 and the insulating pattern 76 of the first insulating structure Isa (in FIG. 2A) in FIG. 2A may be formed. The insulating pattern 76 may include, for example, silicon nitride (Si₃N₄), and the insulating liner 73 covering a side surface and a bottom surface of the insulating pattern 76 may include, for example, silicon oxide (SiOz). The first and second layers 40 and 42 remaining in a lower portion of the line portion 61 may be denoted by reference numerals 40b and 42b. The second insulating structure Isb (in FIG. 2B) in FIG. 2B may include the first to fifth layers 40b, 42b, 44, 46, and 48.

Referring back to FIGS. 1, 2A and 2B, a bit line spacer 85 may be formed on the sidewall of the opening 67, an opening exposing the pad pattern 21 may be formed using an etching process using the bit line capping pattern 64 and the bit line spacer 85 as an etch mask, and a contact structure 88 filling the opening may be formed. A conductive layer for forming the landing pad 90 may be formed on the contact structure 88, and an insulating isolation pattern 92 penetrating the conductive layer may be formed.

In another example, the contact structure 88 and the landing pad 90 may be integrated with each other.

An etch stop layer 94 may be formed on the landing pad 90 and the insulating isolation pattern 92, and a data storage structure 96 electrically connected to the landing pad 90 may be formed. The data storage structure 96 may be a capacitor structure including a first electrode 98a penetrating through the insulating etch stop layer 94 and in contact with the landing pad 90, a dielectric layer 98b covering the first electrode 98a on the insulating etch stop layer 94, and a second electrode 98c disposed on the dielectric layer 98b. The dielectric layer 98b may be interposed between the first electrode 98a and the second electrode 98c, and between the second electrode 98c and the insulating etch stop layer 94.

According to the aforementioned example embodiments, by disposing a reliable and stable insulating structure between conductive regions adjacent to each other, a semiconductor device having enhanced reliability may be provided. For example, a stable insulating structure may be disposed between the pad pattern and the plug portion of the bit line structure and/or between the impurity region and the plug portion of the bit line structure. The insulating structure may include a spacer including a first material, an insulating pattern disposed between the plug portion and the spacer and including a second material different from the first material, and an insulating liner covering a side surface and a bottom surface of the insulating pattern and including a third material different from the first and second materials. Here, the first material may be silicon carbonitride (SiCN), the second material may be silicon nitride (Si₃N₄), and the third material may be silicon oxide (SiOz).

According an example embodiment of the present disclosure, a method of forming the insulating layer in contact with the layer formed of silicon oxide (SiOz) as a silicon carbonitride (SiCN) insulating layer which may be formed using a hexa-chlorodi-silane (HCD, Si₂Cl₆) precursor, and removing the silicon oxide (SiOz) in contact with the silicon carbonitride (SiCN) insulating layer may be provided. By manufacturing the semiconductor device using the method, a semiconductor device having enhanced reliability may be provided.

While the example embodiments have been illustrated and described above, it will be apparent to those skilled in the art that modified examples and variations could be made without departing from the scope of the present disclosure as defined by the appended claims.

## Claims

1. A semiconductor device, comprising:
an active region;
an isolation region disposed on a side surface of the active region;
a gate trench intersecting the active region and extending into the isolation region;
a gate structure disposed in the gate trench;
a first impurity region and a second impurity region disposed in the active region on both sides of the gate structure and spaced apart from each other;
a bit line structure including a line portion intersecting the gate structure and a plug portion disposed below the line portion and electrically connected to the first impurity region; and
an insulating structure disposed on a side surface of the plug portion,
wherein the insulating structure includes:
a spacer including a first material;
an insulating pattern disposed between the plug portion and the spacer and including a second material different from the first material; and
an insulating liner covering a side surface and a bottom surface of the insulating pattern and including a third material different from the first and second materials.

2. The semiconductor device of claim 1,
wherein the first material is silicon carbonitride,
wherein the second material is silicon nitride, and
wherein the third material is silicon oxide.

3. The semiconductor device of claim 1 or 2,
wherein the spacer includes a first material layer including the first material, and a second material layer including the second material, and
wherein the second material layer is disposed between the first material layer and the insulating liner.

4. The semiconductor device of any preceding claim, wherein a distance between both side surfaces of the spacer is in a range from about 3 Å to about 10 Å.

5. The semiconductor device of any preceding claim, wherein a distance between both side surfaces of the spacer is smaller than a width of the insulating pattern.

6. The semiconductor device of any preceding claim,
wherein an upper surface of the first impurity region is disposed at a level lower than a level of an upper surface of the second impurity region, and
wherein at least a portion of the insulating structure is disposed between the second impurity region and the plug portion.

7. The semiconductor device of any preceding claim, further comprising:
a pad pattern disposed on and contacting the second impurity region; and
an insulating barrier pattern being in contact with a portion of a side surface of the pad pattern,
wherein the pad pattern includes a first side surface in contact with the insulating barrier pattern and a second side surface in contact with the spacer.

8. The semiconductor device of claim 7, wherein the pad pattern includes doped polysilicon.

9. The semiconductor device of claim 7 or 8, further comprising:
a buffer structure,
wherein at least a portion of the buffer structure is disposed between the insulating barrier pattern and the line portion,
wherein the buffer structure includes a first buffer layer and a second buffer layer disposed on the first buffer layer, and
wherein a material of the first buffer layer is different from a material of the second buffer layer.

10. The semiconductor device of claim 9,
wherein the buffer structure further includes a third buffer layer disposed on the second buffer layer, and
wherein a material of the third buffer layer is different from the material of the second buffer layer.

11. The semiconductor device of claim 10,
wherein the buffer structure further includes a fourth buffer layer disposed on the third buffer layer, and
wherein the fourth buffer layer is in contact with a lower surface of the line portion.

12. The semiconductor device of claim 11, wherein the fourth buffer layer is a polysilicon layer.

13. The semiconductor device of any of claims 7 to 12, further comprising:
a contact structure disposed on the pad pattern,
wherein the contact structure is in contact with the insulating structure and the pad pattern, and
wherein the spacer of the insulating structure is in contact with the contact structure.
